# EUROPEAN PATENT APPLICATION

(11) **EP 1 752 494 A1**
(43) Date of publication of application: **14.02.2007**
(21) Application number: 04724799.4
(22) Date of filing: 31.03.2004
(51) Int. Cl.: C08L 63/00

(54) **PHOTO-RADICAL-CURABLE RESIN COMPOSITION CONTAINING EPOXY RESIN**

(71) Applicant: Nichiban Company Limited, Bunkyo-ku, Tokyo 112-8663 (JP)
(72) Inventor: SUGIKI, Takanori c/o NICHIBAN COMPANY LIMITED, Tokyo 112-8663 (JP); NISHIDA, Yuichi c/o NICHIBAN COMPANY LIMITED, Tokyo 112-8663 (JP)
(74) Representative: Goddar, Heinz J.
(86) International application number: PCT/JP2004/004672
(87) International publication number: WO 2005/100472

(57) **Abstract**

A resin composition containing an epoxy resin and a photo-radically curable resin, **characterized by** containing a triphenylmethane-based leuco pigment represented by formula (1): 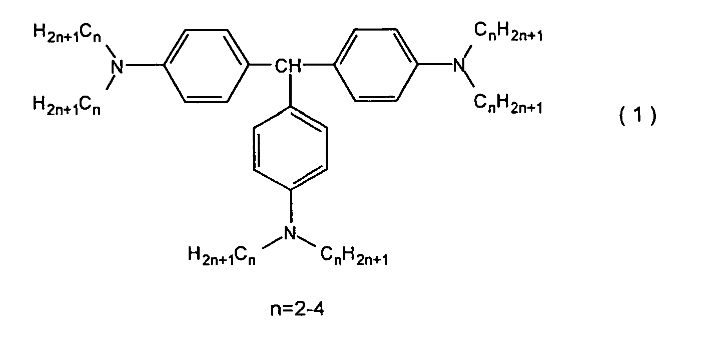 The resin composition makes it possible to visually confirm the cured state thereof during working with ease in a short time period.

## Description

### Technical Field

This invention relates to a resin composition containing an epoxy resin and a photo-radically curable resin, for industrial use as a surface-coating agent, an adhesive, a self-adhesive, a sealant, a paint and so forth, of which the cured state ca be visually confirmed with ease by color developed when it is subjected to photo curing, and a method of confirming the history of photoirradiation, including the cured state of the composition. Further, the present invention relates to a new triphenylmethane-based leuco pigment.

### Background Art

In general, a photo-radically curable resin has been widely used as a surface-coating agent, an adhesive, a self-adhesive, a sealant, a paint and so forth, and as a method of confirming the cured state of the resin, there has been proposed a method in which a leuco crystal violet (LCV), which is changed in color into blue-violet when oxidized by light, is uniformly added to a photo-radically curable resin to thereby color the composition during photoirradiation thereto (Japanese Laid-Open Patent Publication (Kokai) No. S62-153377 (1987), and Japanese Laid-Open Patent Publication (Kokai) No. S62-205180 (1987)).

On the other hand, the present inventors have already proposed a resin composition formed by adding a heat-curable epoxy resin to a photo-radically curable resin (WO 02/44299-A1). This composition is cured by photoirradiation, and then further subjected to heat curing, thereby making it possible to markedly enhance adhesiveness to an adherend, the surface hardness and so forth.

However, the present inventors have found that in the case of a resin composition containing an epoxy resin in a photo-radically curable resin for enhancement of the adhesive performance of the composition and the like, an LCV added for confirmation of curing by photoirradiation ceases to develop color in several days to several weeks if it is subjected to photoirradiation. Further, the present inventors have found that when an LCV is added to a resin composition containing an epoxy resin and a photo-radically curable resin, the viscosity of the whole resin composition increases in storage.

It is an object of the present invention to provide a resin composition, as a solution to the above problems, which contains an epoxy resin and a photo-radically curable resin, and develops color by photoirradiation, thereby making it possible to visually confirm whether or not the resin composition is cured with ease in a short time period, a method of confirming a history of photoirradiation, including the cured state thereof.

### Disclosure of the Invention

As a result of intensive study, the present inventors found that when an LCV is used with a resin composition containing an epoxy resin and a photo-radically curable resin, the LCV reacts with the epoxy resin during storage, to become inactive due to the structure of dimethylaniline as a tertiary amine in the structure of LCV, so that the LCV ceases to develop color in several days to several weeks if it is subjected to photoirradiation, and that the LCV works as a curing catalyst of the epoxy resin to cause polymerization of the epoxy resin and to increase the viscosity of the whole resin composition. Then, the inventors have found out that the aforementioned object can be attained by using an LCV derivative in which methyl groups of the LCV structure are replaced e.g. by ethyl groups, propyl groups, butyl groups, etc., in place of the LCV, and completed the present invention.

More specifically, the present invention provides a resin composition containing an epoxy resin and a photo-radically curable resin, characterized by further containing a triphenylmethane-based leuco pigment represented by formula (1):

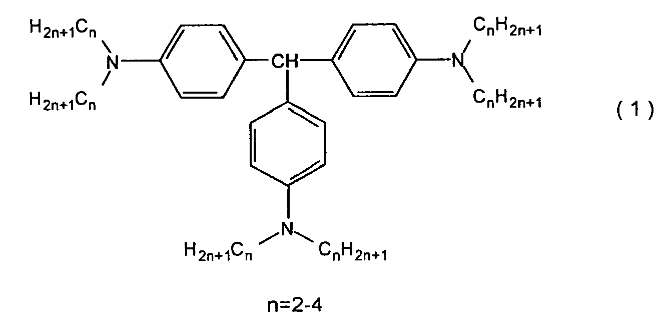

The present invention provides the above-described resin composition, wherein the triphenylmethane-based leuco pigment is 4,4',4"-tris(diethylamino)triphenylmethane (structure represented by n = 2 in the formula (1)).

The present invention provides the above-described resin composition, wherein the photo-radically curable resin contains a compound having a radically polymerizable unsaturated double bond, and a photo-radical polymerization initiator.

The present invention provides a method of confirming the history of photoirradiation to the resin composition, comprising the step of changing in color by irradiation of light to the resin composition.

Further, the present invention provides a triphenylmethane-based leuco pigment represented by the formula (1), provided that bis(4-diethylaminophenyl)-4-N,N-dipropylaminophenylmethane is excluded.

### Best Mode for Carrying Out the Invention

The triphenylmethane-based leuco pigment according to the present invention has the above-described formula (1). This pigment is an LCV derivative having a structure in which methyl groups in the dimethylaniline structure of the LCV are replaced by straight-chain or branched-chain alkyl groups having 2 to 4 carbon atoms. As the alkyl groups, the straight-chain and branched chain alkyl groups having 2 to 4 carbon atoms may coexist. Preferable alkyl group is ethyl group, n-propyl group or n-butyl group. It is particularly preferable that all the alkyl groups are ethyl groups, that is 4,4'4"-tris(diethylamino)triphenylmethane.

In the resin composition of the present invention, radicals generated from a photo-radical polymerization initiator during photoirradiation polymerize and cure a photo-radically curable resin. At this time, if the abovementioned LCV derivative has been added in advance to the resin composition, abstraction of methine hydrogens of the LCV derivative occurs simultaneously, whereby double bonds thereof are conjugated to develop color. This makes it possible to visually confirm the degree of photo-curing of the resin composition even in the coexistence of the epoxy resin.

Further, the resin composition according to the present invention is not cured by polymerization of the epoxy resin during its storage even if the LCV derivative is added in advance, so that the resin composition can be put in storage for a long time.

The above-described LCV derivative can be synthesized easily by a known method disclosed e.g. in Japanese Laid-Open Patent Publication (Kokai) No. H2-58573 (1990), or the like methods.

Although the amount of the LCV derivative added to the resin composition depends on the type and the physical property of the resin composition, if it is too small, coloring density is lowered to degrade the effectiveness of the confirming method, whereas if it is too large, the LCV derivative may absorb light to cause inhibition of curing of the same. The amount of the LCV derivative to be added is 0.005 to 5 wt%, preferably 0.005 to 0.5 wt%, with respect to the resin composition.

The resin composition of the present invention functions essentially independently of the amount ratio between the epoxy resin and the photo-radically curable resin. Although in the conventional method using the LCV, it was impossible to attain the object of the present invention even in the presence of a slight amount of the epoxy resin, the present invention has made it possible to attain the object irrespective of the amount of the epoxy resin.

The epoxy resin in the resin composition of the present invention is not particularly limited, but examples thereof include bisphenol A epoxy resins, bisphenol F epoxy resins, novolac epoxy resins, dimer acid diglycidyl esters, and glycol diglycidyl ethers.

Although it suffices that the epoxy resin in the resin composition exists even in a very small amount, it is preferable that the content of the epoxy resin in the resin composition of the present invention is preferably 0.5 to 90 wt%, particularly preferably 5 to 80 wt%, and further preferably 10 to 70 wt%, with respect to the resin composition.

The photo-radically curable resin in the resin composition of the present invention may contain a compound having a radically polymerizable unsaturated double bond, and a photo-radical polymerization initiator, as main components.

The content of the photo-radically curable resin in the resin composition of the present invention is not particularly limited, but the content of the photo-radically curable resin is preferably 10 to 99.5 wt%, particularly preferably 20 to 95 wt%, and further preferably 30 to 90 wt%, with respect to the resin composition.

The compound having a radically polymerizable unsaturated double bond is not particularly limited, but examples thereof include (meth)acrylic monomers, (meth)acrylic oligomers, vinyl monomers, allylic compounds, and so forth.

Examples of the (meth)acrylic monomers include alkyl (meth)acrylates, such as ethyl(meth)acrylate, butyl(meth)acrylate, 2-ethylhexyl(meth)acrylate, and isooctyl(meth)acrylate; (meth)acrylic acid, 2-hydroxyethyl(meth)acrylate, polyethylene glycol(meth)acrylate, isobornyl(meth)acrylate, phenoxyethyl(meth)acrylate, 1,4-butanediol di(meth)acrylate, and trimethylolpropane tri(meth)acrylate.

Examples of the (meth)acrylic oligomers include epoxy(meth)acrylate, urethane(meth)acrylate, polyester(meth)acrylate, and polybutadiene(meth)acrylate.

Examples of the vinyl monomer include vinyl acetate, styrene, vinyl methyl ether, and acrylamide.

Examples of the allylic compound include diallyl isophthalate acid, diallyl adipate, diallyl maleate, triallyl trimellitate, and so forth.

The photo-radical polymerization initiator may be any of a photo cleavage type and a photo hydrogen abstraction type. Examples of the photo-radical polymerization initiator include benzoyl initiators, benzoin alkyl ether initiators, acetophenone initiators, benzophenone initiators, phosphine oxide initiators, thioxanthone initiators, and so forth. The amount of the photo-radical polymerization initiator to be added is 0.001 to 20 wt%, preferably 0.01 to 10 wt%, and particularly preferably 0.1 to 5 wt%, with respect to the compound having a radically polymerizable unsaturated double bond.

The resin composition of the present invention may contain an epoxy curing agent, a thermoplastic resin, a filler, a colorant (pigment or dyestuff), an antioxidant, a stabilizer, and so forth, as required.

As the epoxy curing agent, a heat-activation type curing agent is preferred, and examples thereof include dicyandiamides, imidazole salts, Lewis acid salts, and dihydrazides.

Examples of the thermoplastic resin include polyethylenes, polypropylenes, polyesters, polyamides, polybutadienes, polybutenes, polyisoprenes, polyvinyl butyrals, ethylene-vinyl acetate copolymers, ethylene-ethylacrylate copolymers, polyvinyl acetates, polyvinyl chlorides, polystyrenes, styrene-butadiene rubbers, acrylonitrile-butadiene rubbers, styrene-butadiene-styrene block copolymers, styrene-isoprene-styrene block copolymers, etc.

Examples of the filler include inorganic powders, such as silica, aluminium hydroxide, titanium oxide, calcium carbonate, and talc, and organic powders, such as polymethylmethacrylate fine particles.

Examples of the colorant (pigment or dyestuff) include extender pigments, such as barium sulfate, barium carbonate, clay, and alumina, and fluorescent dyes, such as perylenes, diphenylanthracenes, etc. Examples of the antioxidant include quinolines, hydroquinones, monophenols, polyphenols, hindered phenols, etc. Examples of the stabilizer include salicylic acid derivatives, benzophenones, benzotriazoles, hindered amines, etc.

The resin composition of the present invention can be manufactured by known methods including a method of dissolving or uniformly dispersing the components by stirring with e.g. a high-speed stirrer and then defoaming the mixture.

Although the resin composition of the present invention is preferably in the form of viscous paste at room temperature and transparent, the characteristics of the composition can be designed as required according to the use of the resin composition insofar as the object of the present invention is not compromised.

The resin composition of the present invention is cured by photoirradiation to the surface thereof. The light is only required to serve as an energy source, which is able to radically polymerize monomers and oligomers having an unsaturated double bond, such as ultraviolet rays, electron beams or infrared rays. As the light source, there may be used known lamps, such as a xenon lamp and a metal halide lamp, and an electron beam generator.

After being subjected to photo curing, the resin composition of the present invention is further subjected to heat curing. The heat curing makes it possible to markedly enhance adhesiveness to an adherend and the surface hardness of the resin composition.

### [Examples]

Hereinafter, the present invention will be described with reference to Examples, but should not be considered limited thereto.

### [Synthesis of Pigment 1 (LCV Analog 1)]

32.8 g of diethylaniline, 17.7 g of p-N,N-diethylaminobenzaldehyde, and 1.6 g of urea were added to 30 ml of isopropyl alcohol, and then 11.5 g of 95% sulfuric acid (% represents wt%; the same applies to the following description) was gradually added to the mixture under stirring. After refluxing for 24 hours, the obtained mixture was poured into water. 20% sodium hydroxide solution was added for adjustment to pH 8-9, and the mixture was subjected to extraction with toluene. After that, a residue obtained by drying the toluene layer under reduced pressure to solid was recrystallized from ethanol, whereby 21 g of pale gray crystal of 4,4',4"-tris(diethylamino)triphenylmethane (yield 46%) was obtained.

### [Synthesis of Pigment 2 (LCV Analog 2)]

38.9 g of dipropylaniline, 20.5 g of p-N,N-dipropylaminobenzaldehyde, and 1.6 g of urea were added to 30 ml of isopropyl alcohol, and then 11.5 g of 95% sulfuric acid was gradually added to the mixture under stirring. After refluxing for 24 hours, the mixture obtained was poured into water. 20% sodium hydroxide solution was added for adjustment to pH 8-9, and the mixture was subjected to extraction with toluene. After that, a residue obtained by drying under reduced pressure to solid was recrystallized from ethanol, whereby 23 g of pale gray crystal of 4,4',4"-tris(dipropylamino)triphenylmethane (yield 43%) was obtained.

### [Synthesis of Pigment 3 (LCV Analog 3)]

45.1 g of dibutylaniline, 23.3 g of p-N,N-dibutylaminobenzaldehyde, and 1.6 g of urea were added to 30 ml of isopropyl alcohol, and then 11.5 g of 95% sulfuric acid was gradually added to the mixture under stirring. After refluxing for 24 hours, the obtained mixture was poured into water. 20% sodium hydroxide solution was added for adjustment to pH 8-9, and the mixture was subjected to extraction with toluene. After that, a residue obtained by drying under reduced pressure to solid was recrystallized from ethanol, whereby 25 g of pale gray crystal of 4,4',4"-tris(dibutylamino)triphenylmethane (yield 40%) was obtained.

### [Manufacturing of Resin Compositions 1 to 5]

Each of compositions shown in TABLE 1 was uniformly mixed by a high-speed stirrer while controlling temperature to 50°C or less with light shielding, whereby viscous resin compositions were obtained.

**TABLE 1 Composition**

| Component Name | Description of Component | Composition 1 | Composition 2 | Composition 3 | Composition 4 | Composition 5 |
|---|---|---|---|---|---|---|
| SHIKO UV7000B (Nippon Synthetic Chemicals Industry Co., Ltd.) | urethane acrylate oligomer | 100 | | 50 | 30 | 50 |
| LIGHT-ACRYLATE P0-A (KYOEISHA CHEMICALS Co., LTD) | phenoxyethyl acrylate | | 100 | 50 | 20 | 80 |
| Epikote 828 (Japan Epoxy Resins Co., Ltd.) | epoxy resin | 50 | 50 | 50 | 100 | 20 |
| Kraton D1155 (Kraton Polymers) | ethylenebutadienestyrene block copolymer | | 10 | 5 | | 10 |
| AEROSIL 200 (JAPAN AEROSIL Co., LTD) | anhydrous silica | 10 | | | | |
| AEROSIL R972 (JAPAN AEROSIL Co., LTD) | hydrophobic silica | | 10 | 10 | | 10 |
| DICY-15 (Japan Epoxy Resins Co., Ltd.) | epoxy curing agent | 3 | 3 | 3 | 6 | 1.2 |
| Darocure 1173 (Ciba Specialty Chemicals Inc) | photo-radical polymerization initiator | 1 | 1 | 1 | 0.5 | 1.3 |

### Examples 1 to 7

Pigments were mixed with the resin compositions according to the combinations as shown in TABLE 2, and they were sufficiently dissolved. The rises in the viscosity of the mixtures and changes in colors thereof before and after UV irradiation were checked immediately after preparation, after storage at 23°C for one month with light shielding or after storage at 40°C for one month with light shielding. The mixed solutions were stored at 23°C for one month with light shielded immediately after preparation. Then, after storage at 40°C for one month with light shielded, Curing caused by photo-radical polymerization by UV irradiation was recognized in each mixture.

In Examples 1 to 7, the mixtures were stable with no changes in viscosity after the storage, and sharp changes in colors caused by UV irradiation could be observed. On the other hand, in Comparative Examples 1 to 5, rises in the viscosity of the mixtures, caused by the storage were observed, and changes in color of the mixtures, caused by UV irradiation, were small. As a matter of fact, the changes in color in Comparative Examples 1 to 5 were not at such a level enough to visually confirm whether or not UV irradiation curing was performed.

**TABLE 2 Example and Comparative Example**

| | Resin Composition No. | Pigment No. 0.05% | Immediately After Preparation | | After 23°C x One Month Storage | | | After 40°C x One Month Storage | | |
|---|---|---|---|---|---|---|---|---|---|---|
| | | | Color | | Increase in Viscosity | Color | | Increase in Viscosity | Color | |
| | | | Before UV | After UV | Before UV | | After UV | Before UV | | After UV |
| Example 1 | 1 | 1 | white | blue-violet | none | white | blue-violet | none | white | blue-violet |
| Example 2 | 1 | 2 | white | blue-violet | none | white | blue-violet | none | white | blue-violet |
| Example 3 | 1 | 3 | white | blue-violet | none | white | blue-violet | none | white | blue-violet |
| Example 4 | 2 | 1 | white | blue-violet | none | white | blue-violet | none | white | blue-violet |
| Example 5 | 3 | 2 | white | blue-violet | none | white | blue-violet | none | white | blue-violet |
| Example 6 | 4 | 3 | white | blue-violet | none | white | blue-violet | none | white | blue-violet |
| Example 7 | 5 | 1 | white | blue-violet | none | white | blue-violet | none | white | blue-violet |
| Comparative Example 1 | 1 | LCV | white | blue-violet | slight increase | white | pale blue | large | white | white |
| Comparative Example 2 | 2 | LCV | white | blue-violet | slight increase | white | pale blue | large | white | white |
| Comparative Example 3 | 3 | LCV | white | blue-violet | slight increase | white | pale blue | large | white | white |
| Comparative Example 4 | 4 | LCV | white | blue-violet | large | white | white | gelated | white | white |
| Comparative Example 5 | 5 | LCV | white | blue-violet | none | white | pale blue | slight increase | white | white |

| | | | | | | | | | | |
|---|---|---|---|---|---|---|---|---|---|---|
| LCV: manufactured by Yamamoto Chemicals, Co., Ltd. | | | | | | | | | | |

### Industrial Applicability

According to the present invention, it is possible to obtain a resin composition containing an epoxy resin and a photo-radically curable resin, which has excellent preservability, develops color by photoirradiation during working, thereby making it possible to visually confirm the cured state thereof with ease in a short time period, and at the same time is excellent in adhesiveness to an adherend, the hardness of surfaces thereof, etc. after being subjected to photo curing and following heat curing.

Further, according to the present invention, it is possible to provide a method of visually confirming the history of photoirradiation to a resin composition containing an epoxy resin and a photo-radically curable resin with ease in a short time period.

Furthermore, according to the present invention, it is possible to provide a new triphenylmethane-based pigment which, in the presence of an epoxy resin, has excellent preservability, and develops color by photoirradiation when working a photo-radically curable resin, thereby making it possible to visually confirm the cured state of a resin composition with ease in a short time period.

## Claims

1. A resin composition containing an epoxy resin and a photo-radically curable resin, **characterized by** containing a triphenylmethane-based leuco pigment represented by formula (1):

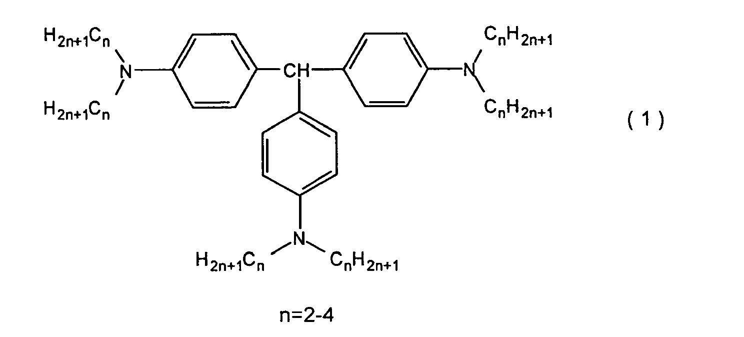

2. The resin composition according to claim 1, wherein the triphenylmethane-based leuco pigment is 4,4',4"-tris(diethylamino)triphenylmethane, that is the structure represented by formula (1) wherein n=2.

3. The resin composition according to claim 1 or 2, wherein the photo-radically curable resin contains a compound having a radically polymerizable unsaturated double bond, and a photo-radical polymerization initiator.

4. A method of confirming the history of photoirradiation to a resin composition according to any one of claims 1 to 3, comprising the step of changing color by irradiation of light to the resin composition.

5. A triphenylmethane-based leuco pigment represented by formula (1): 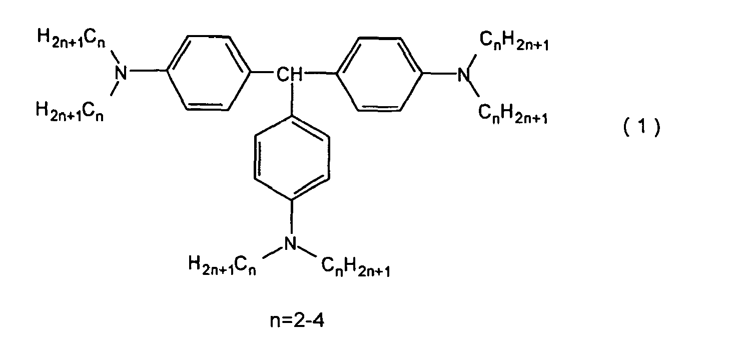 , provided that bis(4-diethylaminophenyl)-4-N,N-dipropylaminophenylmethane is excluded.

6. 4,4',4"-tris(diethylamino)triphenylmethane.
